# EUROPEAN PATENT SPECIFICATION

(11) **EP 4 460 916 B1**
(45) Date of publication and mention of the grant of the patent: **16.07.2025**
(21) Application number: 22834625.0
(22) Date of filing: 12.12.2022
(51) Int. Cl.: H04B 10/69, H04B 10/11

(54) **IMPROVED PHOTOMULTIPLIER TECHNOLOGY**
VERBESSERTE PHOTOVERVIELFACHERTECHNOLOGIE
TECHNOLOGIE DE PHOTOMULTIPLICATEUR AMÉLIORÉE

(30) Priority: 06.01.2022 US 202263296975 P; 13.01.2022 EP 22151415
(43) Date of publication of application: 13.11.2024
(73) Proprietor: Signify Holding B.V., 5656 AE Eindhoven (NL)
(72) Inventor: BLUSCHKE, Andreas, Felix, Alfred, 5656 AE Eindhoven (NL); JORDAN, Christian, 5656 AE Eindhoven (NL); WILLEBRAND, Heinz, Alex, 5656 AE Eindhoven (NL)
(74) Representative: Verweij, Petronella Daniëlle
(86) International application number: PCT/EP2022/085401
(87) International publication number: WO 2023/131474

(56) References cited:
- US-A1- 2014 183 339
- US-A1- 2017 242 136
- STEFAN GUNDACKER ET AL: "The silicon photomultiplier: fundamentals and applications of a modern solid-state photon detector", PHYSICS IN MEDICINE AND BIOLOGY, INSTITUTE OF PHYSICS PUBLISHING, BRISTOL GB, vol. 65, no. 17, 19 August 2020 (2020-08-19), XP020356667, ISSN: 0031-9155, [retrieved on 20200819], DOI: 10.1088/1361-6560/AB7B2D

## Description

### FIELD OF THE INVENTION

The present invention generally relates to optical communications technology, and more specifically to photomultipliers. More specifically, the proposed technology concerns a readout circuit for a Silicon Photomultiplier, a circuit assembly comprising a Silicon Photomultiplier and such a readout circuit, a Silicon Photomultiplier comprising a readout circuit, a corresponding optical receiver as well as an optical transceiver system.

### BACKGROUND OF THE INVENTION

In general, a photomultiplier is a device that converts incident photons into an electrical signal.

Photomultipliers may be used for photon sensing in various applications such as Time-of-Flight (ToF) applications, e.g. for sensing and/or for measuring distances to objects. More recently, it has also been suggested to use photomultipliers for Optical Wireless Communications (OWC), but with limited practical success and performance.

In order to enable better performance and use of photomultipliers, e.g. in OWC or ToF applications and other application areas, continued research and development is necessary for designing improved circuitry for photomultipliers.

US 2017/242136 discloses a semiconductor photomultiplier, SPM, device. The SPM comprises a plurality of photosensitive elements, a first electrode arranged to provide a bias voltage to the photosensitive elements, a second electrode arranged as a biasing electrode for the photosensitive elements, a plurality of quench resistive elements each associated with a corresponding photosensitive element, a plurality of output loads each having a capacitive load operably coupled to a resistive load in a parallel configuration between first and second nodes; each first node is common to one of the photosensitive elements and the corresponding quench element; and a third electrode coupled to the second nodes of the output loads to provide an output signal from the photosensitive elements. The outputs loads fully or partially correct an overshoot of an output signal on the third electrode.

US 2014/183339 relates to shaping a readout pulse from a solid state photomultiplier (SSPM). A readout pulse can be received from the SSPM at an input of a buffer amplifier. The readout pulse can have a discharge portion with a discharge rate and a recharge portion with a recharge rate. A magnitude of the readout pulse increasing for the discharge portion and decreasing for the recharge portion. A frequency dependent input impedance circuit can be employed in electrical communication with the input of the buffer amplifier to shape the discharge portion of the readout pulse.

Publication "The silicon photomultiplier: fundamentals and applications of a modern solid-state photon detector" relates to a silicon photomultiplier (SiPM), which is an established device of choice for a variety of applications, e.g. in time of flight positron emission tomography (TOF-PET), lifetime fluorescence spectroscopy, distance measurements in LIDAR applications, astrophysics, quantum-cryptography and related applications as well as in high energy physics (HEP).

There is thus a general demand for improved circuit solutions in the field of photomultiplier technology.

### SUMMARY OF THE INVENTION

It is desirable to provide improved circuit designs related to photomultipliers, especially for Silicon Photomultipliers (SiPM).

It is an object to provide a readout circuit for a Silicon Photomultiplier (SiPM).

It is another object to provide a circuit assembly comprising a Silicon Photomultiplier (SiPM) and a readout circuit.

Yet another object is to provide a Silicon Photomultiplier (SiPM) comprising a readout circuit.

Still another object is to provide an optical receiver comprising a circuit assembly or a Silicon Photomultiplier (SiPM).

It is also an object to provide an optical transceiver system.

These and other objects are achieved by embodiments defined in the claims.

According to a first aspect of the invention, there is provided a readout circuit for a Silicon Photomultiplier (SiPM), said Silicon Photomultiplier having a first main output (Sout) as well as a capacitively coupled second output (Fout). The readout circuit comprises:
- a combiner having inputs for receiving signals originating from the first main output (Sout) and the second output (Fout) of the Silicon Photomultiplier and configured to generate a combined signal based on the received signals,
- a first signal path defined between the first main output (Sout) of the Silicon Photomultiplier and a first one of the inputs of the combiner; and
- a second signal path defined between the second output (Fout) of the Silicon Photomultiplier and a second one of the inputs of the combiner; and
- circuitry for arrangement in at least one of the first signal path and the second signal path and configured to at least partially provide isolation between the first main output (Sout) and the second output (Fout) of the Silicon Photomultiplier during operation.

According to a second aspect of the invention, there is provided a circuit assembly comprising a Silicon Photomultiplier (SiPM) and a readout circuit.

According to a third aspect of the invention, there is provided a Silicon Photomultiplier (SiPM) comprising such a readout circuit.

According to a fourth aspect of the invention, there is provided an optical receiver comprising such a circuit assembly or a Silicon Photomultiplier (SiPM).

According to a fifth aspect of the invention, there is provided a corresponding optical transceiver system.

In other words, the present invention is based on the idea of providing and/or maintaining isolation between the first main output (Sout) and the second output (Fout) of the Silicon Photomultiplier, and performing signal combination to generate a combined signal based on the received signals originating from the first main output (Sout) and the second output (Fout), while possibly performing individual signal processing such as filtering in the first signal path and/or second signal path.

The present invention is particularly advantageous in that it provides a photomultiplier, an overall circuit assembly and/or an optical transceiver having improved frequency operating range and/or reduced pattern-based jitter.

Further objectives of, features of, and advantages with, the present invention will become apparent when studying the following detailed disclosure, the drawings and the appended claims. Those skilled in the art will realize that different features of the present invention can be combined to create embodiments other than those described in the following.

### BRIEF DESCRIPTION OF THE DRAWINGS

This and other aspects of the present invention will now be described in more detail, with reference to the appended drawings showing embodiment(s) of the invention.
Fig. 1 schematically shows an example of a photomultiplier according to the prior art;
Fig. 2 is a schematic diagram illustrating an example of a photomultiplier and a novel readout circuit according to an exemplifying embodiment;
Fig. 3 is a schematic diagram illustrating another example of a photomultiplier and a novel readout circuit according to an exemplifying embodiment;
Fig. 4 is a schematic diagram illustrating a particular example of a filter circuit according to an exemplifying embodiment;
Fig. 5 is a schematic simplified circuit diagram illustrating a particular example of a photomultiplier and a novel readout circuit according to an exemplifying embodiment;
Fig. 6 is a schematic diagram illustrating another particular example of a photomultiplier and a novel readout circuit according to an exemplifying embodiment;
Fig. 7 is a schematic diagram illustrating an example of an optical transceiver system according to an exemplifying embodiment.

### DETAILED DESCRIPTION

For a better understanding, it may be useful to begin with a brief overview of the basics of photo multipliers, and Silicon Photomultipliers (SiPM) in particular.

As mentioned, photomultipliers may be used for photon sensing in various applications such as Time-of-Flight (ToF) applications, e.g. for sensing and/or for measuring distances to objects. More recently, it has also been suggested to use photomultipliers for Optical Wireless Communications (OWC), but with limited practical success and performance.

A particular type of photomultiplier is the Silicon Photomultiplier, often called "SiPM" in the literature. The SiPM is a solid-state single-photon-sensitive device, e.g. based on a Single-Photon Avalanche Diode (SPAD) implemented on a common silicon substrate.

When a photon travels through silicon, it may be absorbed and transfer energy to a bound electron. This absorbed energy causes the electron to move from the valence band into the conduction band, creating an electron-hole pair. Silicon efficiently absorbs a wide range of wavelengths of light within a depth of a few tens of microns and so is well-suited as a photodetector material. As the photon absorption is wavelength dependent, it follows that the resulting photon detection efficiency of a silicon photosensor will also be wavelength dependent.

A photodiode operated in Geiger mode employs a breakdown mechanism to achieve a high gain and is normally referred to as a SPAD. The application of a reverse bias beyond its nominal breakdown voltage creates the necessary high-field gradients across the junction. Once a current is flowing it should then be quenched. Passive quenching may for example be achieved by using a series resistor that limits the current drawn by the diode during breakdown. This lowers the reverse voltage seen by the diode to a value below its breakdown voltage, thus halting the avalanche. The diode then recharges back to the bias voltage, and is available to detect subsequent photons.

To overcome the inherent lack of proportionality, the Silicon Photomultiplier (SiPM) normally integrates an array of independent SPAD sensors, each with its own quenching mechanism. Each independently operating unit consisting of a SPAD and quench mechanism may be referred to as a microcell. When a microcell in the SiPM fires in response to an absorbed photon, a Geiger avalanche is initiated causing a photocurrent to flow through the microcell. This results in a voltage drop across the quench resistor, which in turn reduces the bias across the diode to a value below the breakdown, thus quenching the photocurrent and preventing further Geiger-mode avalanches from occurring.

Each microcell detects photons identically and independently. The sum of the photocurrents from each of these individual microcells combines to form a quasi-analog output, and is thus capable of giving information on the magnitude of an instantaneous photon flux.

Silicon Photomultipliers have been used extensively for Time-of-Flight (ToF) applications where they replace an increasing number of Avalanche Photo Diodes (APDs). Reasons include cost, speed, and high sensitivity for ToF applications. Unfortunately, those devices suffer from high fall times caused by the microcell recharge time constant which is making them already unusable for high-speed Optical Wireless Communications (OWC).

OWC generally refers to transmission in unguided propagation media through the use of optical carriers, where unguided visible, infrared (IR), or ultraviolet (UV) light is used to carry a signal. It is generally used in short-range communication.

A modification to the standard SiPM structure made by OnSemi consists of an extra terminal in addition to the anode and cathode, as suggested in the technical specification "Introduction to the Silicon Photomultiplier (SiPM) - AND9770/D" [1]. This extra terminal is typically referred to as a fast output carrying an ultra-fast output signal. Each microcell thereby has an additional capacitively coupled output - the fast output. The fast output, like the anode-cathode output, is formed from the sum of all microcells, and thereby proportional information on the magnitude of the photon flux can be obtained.

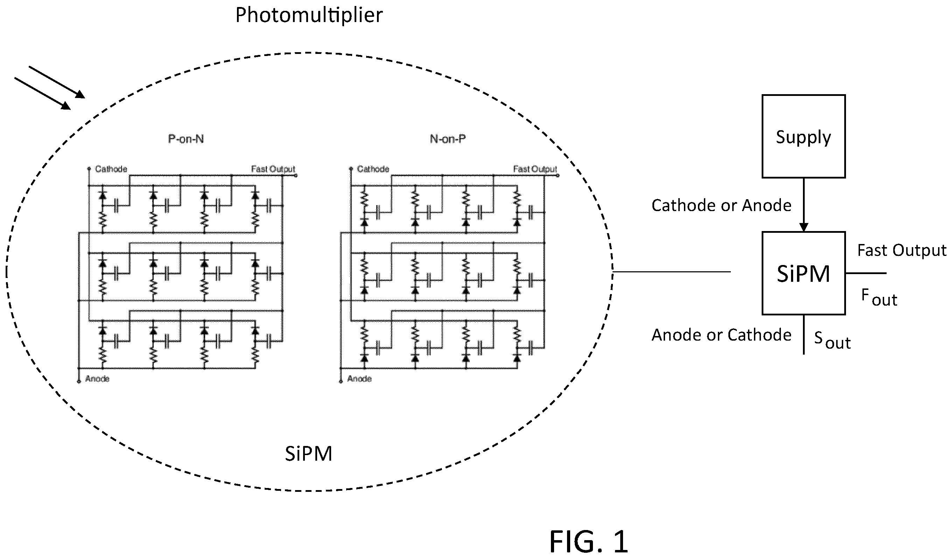

Fig. 1 schematically shows an example of a photomultiplier according to the prior art. Basically, the SiPM is based on an array of microcells. For example, each microcell may include a Single Photon Avalanche Diode (SPAD) and a quench resistor. The SiPM includes a first main output denoted Sout, being a cathode-based output node or an anode-based output node of the SiPM. The SiPM also includes a fast output node denoted Fout, which is a capacitively coupled output node tapping into the Silicon Photomultiplier between a photodiode and a quenching component of each microcell.

The SiPM may be a P-on-N or an N-on-P type diode structure. The polarity of the fast output is determined by the sensor type. The fast output polarity is positive for P-on-N sensor types and negative for N-on-P sensor types. Various biasing options may be used accordingly.

For more information on SiPM, reference can be made to the technical specifications "Introduction to the Silicon Photomultiplier (SiPM) - AND9770/D" [1] and "Biasing and Readout of ON Semiconductor SiPM sensors - AND 9782/D" [2] from OnSemi.

Further reference can also be made to US Patent Application Publication 2021/0193859 [3] regarding anode sensing for Single-Photon Avalanche Diodes (SPAD).

However, although Silicon Photomultipliers have fast rise-time, they also have a slow fall-time, making them less suitable for high-speed optical communications, and especially optical wireless communications (OWC).

The OnSemi SiPM eases the problem of slow fall time by providing the additional fast output node on the SIPM. However, a drawback is that a disturbing jitter occurs during certain operational modes. For example, when using so-called On-Off Keying (OOK) and/or Pulse Amplitude Modulation (PAM), a drawback is that a disturbing jitter occurs based on the applied modulation pattern and speed.

In particular, the OnSemi SiPM fast output node induces a high frequency cutoff, which produces a signal pattern dependent jitter if Consecutive Identical Digits (CIDs) occur, which is of course normal, but unwanted in OWC for OOK and/or PAM. In OFDM based systems it reduces the achievable spectral efficiency at lower frequencies, usually below 30MHz, and this is especially problematic when high-power LEDs with cutoff frequencies below 30MHz are used in OWC.

In practice, this means that conventional Silicon Photomultipliers are actually not designed, nor suitable for OWC.

More specifically, the inventors have realized that the Sout node and Fout node have different frequency responses, and that Sout has an undesired high-frequency behavior and Fout has an undesired low-frequency behavior. Fout has a high low-frequency cutoff causing signal pattern dependent jitter. Sout does not suffer from this problem, but because of the low high-frequency cutoff, the Sout node cannot be used for high-speed signals.

The present invention will overcome this and other problems by using a novel circuit modification/addition involving a new readout circuit for a Silicon Photomultiplier.

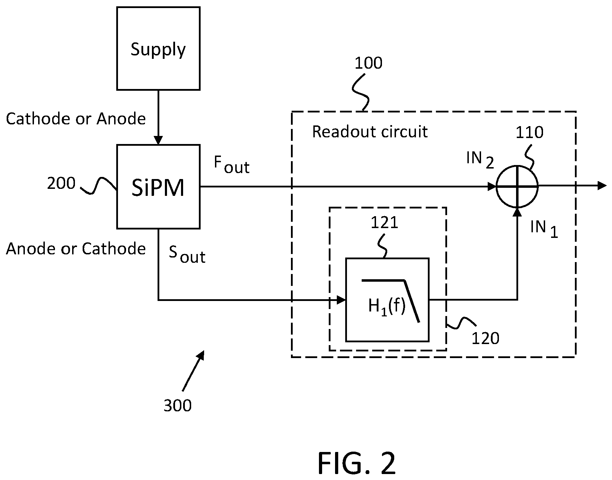

Fig. 2 is a schematic diagram illustrating an example of a photomultiplier and a novel readout circuit according to an exemplifying embodiment of the present invention.

According to a first aspect of the invention, there is provided a readout circuit 100 for a Silicon Photomultiplier (SiPM) 200, wherein the Silicon Photomultiplier 200 has a first main output Sout as well as a capacitively coupled second output Fout.

Basically, the readout circuit 100 comprises a combiner 110 having inputs IN1, IN2 for receiving signals originating from the first main output Sout and the second output Fout of the Silicon Photomultiplier 200 and configured to generate a combined signal based on the received signals.

A first signal path is defined or definable between the first main output Sout of the Silicon Photomultiplier 200 and a first one IN1 of the inputs of the combiner, and a second signal path is defined or definable between the second output Fout of the Silicon Photomultiplier 200 and a second one IN2 of the inputs of the combiner 110.

Further, the readout circuit 100 comprises circuitry 120 for arrangement in at least one of the first signal path and the second signal path and configured to at least partially provide isolation between the first main output Sout and the second output Fout of the Silicon Photomultiplier 200 during operation.

As can be seen in Fig. 2, an overall circuit assembly 300 may be defined as the aggregation of the Silicon Photomultiplier (SiPM) 200 and the readout circuit 100. It should be clear that the Silicon Photomultiplier (SiPM) 200 may be connected to the readout circuit 100.

Alternatively, the Silicon Photomultiplier (SiPM) 200 may include the readout circuit 100. In practice, this would mean that the readout circuit 100 is integrated into an overall Silicon Photomultiplier circuitry.

The present invention is particularly advantageous in that it provides a photomultiplier, an overall circuit assembly and/or an optical transceiver having improved frequency operating range and/or reduced pattern-based jitter.

In a sense, a basic idea is to provide and/or maintain isolation between the first main output (Sout) and the second output (Fout) of the Silicon Photomultiplier, and perform signal combination to generate a combined signal based on the received signals originating from the first main output (Sout) and the second output (Fout), while possibly performing individual signal processing such as filtering in the first signal path and/or second signal path.

Combining the Sout and Fout signals give a better frequency operating range, which also removes the effect caused by pattern-based jitter.

By way of example, the invention may be especially useful for OWC based systems using On-Off Keying (OOK) and/or Pulse Amplitude Modulation (PAM). In practice, the present invention allows for reduced jitter and/or higher spectral efficiency when using Optical - Orthogonal Frequency Division Multiplexing (O-OFDM) based modulation like e.g., DC-based Optical OFDM (DCO-OFDM).

In fact, it is not known to use SiPM for OWC based systems using On-Off Keying (OOK) and/or Pulse Amplitude Modulation (PAM), and in a sense, the invention can be regarded as an enabler for such applications.

For example, the invention makes it possible to avoid computationally intensive, inefficient and impractical encoding/decoding algorithms implemented in the PHY Layer of a communication device. For example, as the responsivity of an SiPM in the visible light region is very good, the proposed solution may provide new opportunities when using modulated lamps instead of separate IR transceivers.

The invention can be used in LiFi products with different modulations schemes, wavelengths, and operate as a highly sensitive and high-speed optical receiver. This can also be very interesting ToF applications.

The unique benefit results from the fact that there is no need to adjust the PHY-Layer of a communication system thus making the receiver suitable for standard OOK modulation like 1000Base-X, OFDM based solution like G.vlc or IEEE802.11 or even PAM-3 and above based modulation schemes based on commonly applied Intensity Modulation and Direct Detection (IM/DD). IM/DD is basically a modulation scheme where the intensity of an optical source is modulated by an RF or mm-wave signal. Demodulation may be achieved through direct detection of the optical carrier and conversion using a photodetector.

Preferably, the combined signal output of the combiner 110 has signal characteristics matching the optical input signal to which the Silicon Photomultiplier 200 is exposed during operation.

By way of example, the circuitry 120 may comprise a first filter circuit 121 arranged in the first signal path between the first main output Sout of the Silicon Photomultiplier 200 and a first one IN1 of the inputs of the combiner 110. In general, the first filter circuit 121 may be defined as having a first frequency response transfer function Hi(f).

For example, the first filter circuit 121 may be configured to adjust the signal level of the signal originating from the first main output Sout and at least partially provide isolation between the first main output Sout and the second output Fout.

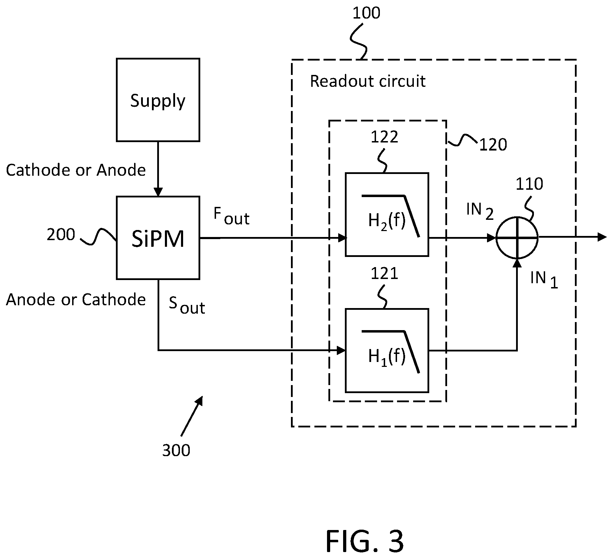

Fig. 3 is a schematic diagram illustrating another example of a photomultiplier and a novel readout circuit according to an exemplifying embodiment.

In this particular example, the circuitry 120 further comprises a second filter circuit 122 arranged in the second signal path between the second output Fout of the Silicon Photomultiplier 200 and a second one IN2 of the inputs of the combiner 110.

The second filter circuit 122 may be defined as having a second frequency response transfer function H₂(f).

In this example, the first filter circuit 121 and the second filter circuit 122 may be configured to terminate the signals originating from the first main output Sout and the second output Fout, respectively, to provide isolation between the first main output Sout and the second output Fout.

For example, the second filter circuit 122 may configured to adjust the signal level of the signal originating from the second output Fout.

The circuitry 120 may include passive and/or active circuitry, and the first filter circuit 121 and/or the second filter circuit 122 may be, e.g., passive filters or active filters. Each filter circuit 121; 122 has a frequency response transfer function, that may be adjustable.

As can be seen in Fig. 3, an overall circuit assembly 300 may be defined as the aggregation of the Silicon Photomultiplier (SiPM) 200 and the readout circuit 100. Alternatively, the Silicon Photomultiplier (SiPM) 200 may include the readout circuit 100.

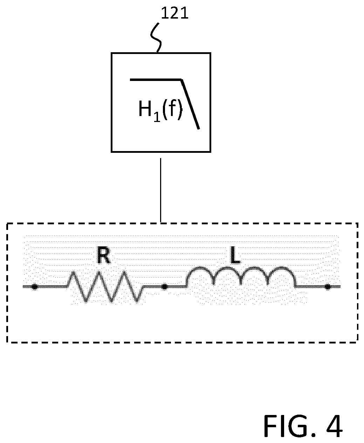

Fig. 4 is a schematic diagram illustrating a particular example of a filter circuit 121 according to an exemplifying embodiment. In this particular example, the first filter circuit may be a passive filter circuit based on a series connection of a resistor R and inductor L.

The Fout signal may be used directly, while the Sout signal should normally be connected in a specific way to not degenerate the performance due to being physically connected to Fout.

By way of example, the inductor L may at least partially isolate the Sout signal from high frequencies emitted by the Fout signal, and may thereby maintain high frequency signal integrity. The resistor R may dampen the Sout signal strength and potential resonance behavior.

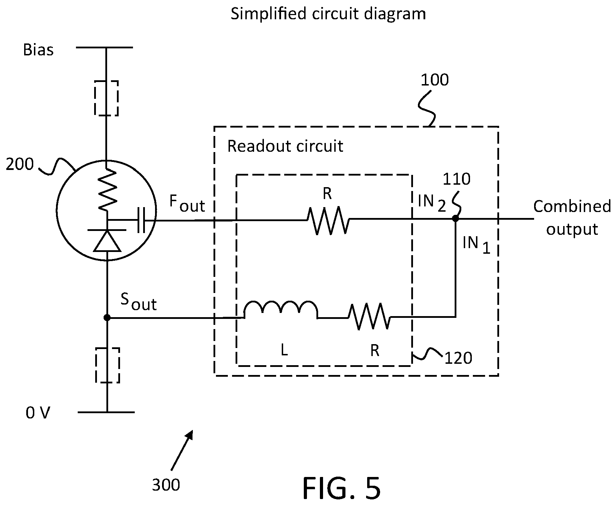

Fig. 5 is a schematic simplified circuit diagram illustrating a particular example of a photomultiplier and a novel readout circuit according to an exemplifying embodiment.

In the example of Fig. 5, the circuitry 120 includes a passive filter circuit based on a series connection of a resistor R and inductor L arranged in the first signal path between the first main output Sout and a first input IN1 of the combiner 110. Further, an additional resistor R may be arranged in the second signal path between the second output Fout and a second input IN2 of the combiner 110.

The inductor L may be used to separate Fout from Sout, while the resistors R may be used to match the amplitudes of the two outputs. The resistors R may have the same or different values. Optionally, a capacitor (not shown) may be arranged in series connection with the inductor L and the resistor R in the first signal path between the first main output Sout and the first input IN1 as an AC-coupling for reducing noise.

The combiner and the inputs IN1, IN2 of the combiner may here be defined by a common interjunction between the first signal path and the second signal path through which the received signals are combined.

As can be seen in Fig. 5, an overall circuit assembly 300 may be defined as the aggregation of the Silicon Photomultiplier (SiPM) 200 and the readout circuit 100. Alternatively, the Silicon Photomultiplier (SiPM) 200 may include the readout circuit 100.

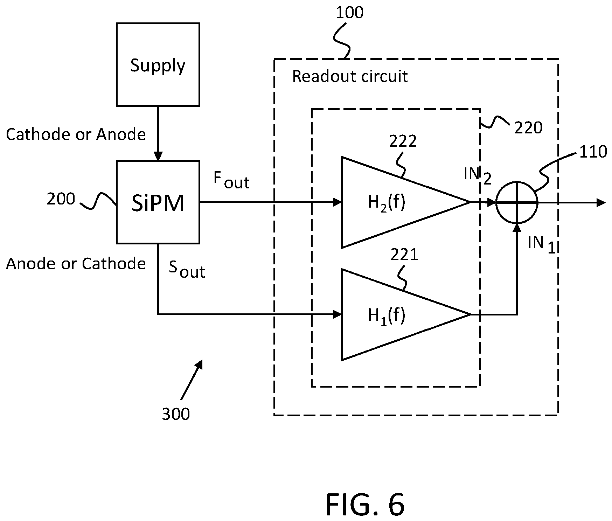

Fig. 6 is a schematic diagram illustrating another particular example of a photomultiplier and a novel readout circuit according to an exemplifying embodiment;

In this particular example, the first filter circuit 221 and the second filter circuit 222 are active filters.

The first filter circuit 221 may be configured to adjust the signal level of the signal originating from Sout, and the second filter circuit 222 may be configured to adjust the signal level of the signal originating from Fout.

Normally, active filters are electronic filters that use active components such as amplifiers. The output is typically not attenuated with respect to the input voltage. The amplifier provides a feedback mechanism from output to input, which enables stability and allows for a wider choice of frequency responses and time domain behavior.

In the example of Fig. 6, the two active filters 221 and 222 form the overall circuitry 220 that is configured to provide isolation between Sout and Fout. In this case, the first filter circuit 221 and the second filter circuit 222 effectively terminate the signals originating from Sout and Fout.

As can be seen in Fig. 6, an overall circuit assembly 300 may be defined as the aggregation of the Silicon Photomultiplier (SiPM) 200 and the readout circuit 100. Alternatively, the Silicon Photomultiplier (SiPM) 200 may include the readout circuit 100.

The advantage of using such an active approach is control over gain, adjustable and definable load impedances, and the capability to drive consecutive stages.

With respect to further information on active and passive filters as such, reference can be made to the "Active and Passive Filters" by Circuits Today [4].

Regardless of whether a passive or active design, or a combination of passive and active design, is used, the basic functionality is to adjust and sum the output signals originating from both Sout and Fout to achieve a signal waveform that matches the optical input waveform the SIPM is exposed to.

In general, the first filter circuit 121; 221 may be is configured to provide a first filtered signal, and the second filter circuit 122; 222 may be configured to provide a second filtered signal, and the combiner 110 may be configured to combine the first filtered signal and the second filtered signal to generate the combined output signal.

The first main output Sout of the Silicon Photomultiplier (SiPM) 200 may be the normal cathode-based or anode-based output node, and the second output Fout of the Silicon Photomultiplier may be fast output node, e.g. as defined in the technical specification "Introduction to the Silicon Photomultiplier (SiPM) - AND9770/D" [1].

In another example, the readout circuit may at least partially be a digital readout circuit comprising analog-to-digital converters (ADCs) for converting the signals originating from the first main output Sout and the second output Fout of the Silicon Photomultiplier 200 into respective digital signals. The first filter circuit 121; 221 and the second filter circuit 122; 222 are then digital filters and the combiner is a digital combiner.

For a digital design, it is naturally required to perform Analog-to-Digital Conversion (ADC) to be able to perform operations in the digital domain.

A digital circuit solution may be desirable if the overall system, in which the photomultiplier is used with or embedded in, already comprises digital processing circuitry such a Digital Signal Processor (DSP). The digital filter(s) may then typically use the processing capabilities of a Digital Signal Processor (DSP) or equivalent circuitry to perform the filtering and signal combining operations. Signal combination may be any form of summation, weighted summation or other form of combination of signals.

As illustrated in Fig. 2, Fig. 3, Fig. 5 and Fig. 6, there is provided an overall circuit assembly 300 that comprises a Silicon Photomultiplier (SiPM) 200 and a readout circuit 100. It is also clear that the Silicon Photomultiplier (SiPM) 200 may be connected to the readout circuit 100.

Alternatively, the Silicon Photomultiplier 200 may include the readout circuit 100. In practice, this would mean that the readout circuit 100 is integrated into the overall Silicon Photomultiplier circuitry 200.

According to a particular aspect, the invention provides an optical receiver comprising a circuit assembly 300 as disclosed herein or a Silicon Photomultiplier 200 as disclosed herein.

For example, the optical receiver may be configured to operate based on On-Off Keying (OOK) and/or Pulse Amplitude Modulation (PAM) for Optical Wireless Communication (OWC).

High rate optical communications may use, e.g. On-Off-Keying (OOK), 4-level Pulse Amplitude Modulation (PAM4) or other multi-level PAM as a basis for efficient transmission. In this context, it should be understood that OOK can be seen as a form of 2-level (On/Off) Pulse Amplitude Modulation.

According to another aspect, the invention provides an optical transceiver system comprising an optical receiver and an optical transmitter.

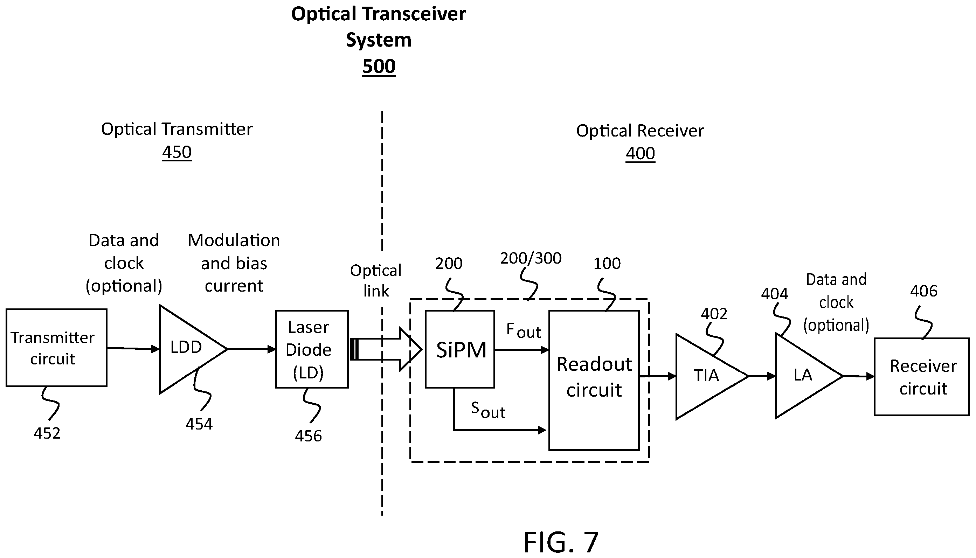

Fig. 7 is a schematic diagram illustrating an example of an optical transceiver system according to an exemplifying embodiment.

In this example, the optical transceiver system 500 basically comprises an optical receiver 400 and an optical transmitter 450 coupled via an optical link such as a wireless optical link or a possibly fiber optical link.

Starting with the optical transmitter 450, it may for example include a transmitter circuit 452 connected to a laser diode driver (LDD) 454 and a laser diode (LD) 456.

For example, the basic transmitter circuit 452 may be configured for generating data and performing all related operation to transmit on the physically medium (e.g., adds coding, determines link speed, and so forth). Usually, the transmitter circuit 452 is an OSI Layer 1 device, whereas the whole communications system is usually at its minimum a Layer 2 entity (e.g., Ethernet) which includes on top of that, e.g., Media Access and so forth.

By way of example, the LDD 454 may be configured to convert the signal of the transmitter circuit 452 into a specific modulation current for a laser or light emitting diode (LED).

The laser diode 456 may be modulated and will typically show a variation in optical power/intensity.

The optical receiver 400 may include the circuit assembly 200/300 comprising a Silicon Photomultiplier 200 and an associated readout circuit 100 as disclosed herein, and additionally a transimpedance amplifier (TIA) 402, a limiting amplifier (LA) 404 and a basic receiver circuit 406.

During operation, the Silicon Photomultiplier 200 is exposed to the light from the laser diode via the optical link, and through the readout circuit 100, the Sout and Fout signals of the photomultiplier 200 are combined into a combined output signal, which is transferred to the transimpedance amplifier 402.

For example, the transimpedance amplifier 402 basically converts the generated small photocurrent of the combined signal into a corresponding voltage. The transimpedance amplifier 402 is connected to the limiting amplifier (LA) 404, which in turn may perform a hard decision of the analog signal converting it into 1's and 0's and outputting the bit stream with an defined signal type such as low voltage differential signaling (LVDS), which is transferred to the receiver circuit 406 for processing.

By way of example, the optical receiver 400 may be operating based on, e.g., IM/DD.

The person skilled in the art realizes that the present invention by no means is limited to the preferred embodiments described above. On the contrary, many modifications and variations are possible within the scope of the appended claims. For example, the circuit components may have different component values and configurations than those depicted/described.

### REFERENCES:

[1] "Introduction to the Silicon Photomultiplier (SiPM) - AND9770/D"; https://www.onsemi.com/pub/collateral/and9770-d.pdf
[2] "Biasing and Readout of ON Semiconductor SiPM sensors - AND 9782/D"; https://www.onsemi.com/pub/collateral/and9782-d.pdf
[3] US Patent Application Publication 2021/0193859
[4] "Active and Passive Filters" by Circuits Today; http://www.circuitstoday.com/active-and-passive-filters

## Claims

1. A readout circuit (100) for a Silicon Photomultiplier, SiPM, (200), said Silicon Photomultiplier, SiPM, (200) having a first main output (Sout) as well as a capacitively coupled second output (Fout), wherein said readout circuit (100) comprises:
- a combiner (110) having inputs (IN1, IN2) for receiving signals originating from said first main output (Sout) and said second output (Fout) of said Silicon Photomultiplier, SiPM, (200) and configured to generate a combined signal based on the received signals,
a first signal path being defined between said first main output (Sout) of said Silicon Photomultiplier, SiPM, (200) and a first one (IN1) of said inputs of said combiner (110); and
a second signal path being defined between said second output (Fout) of said Silicon Photomultiplier, SiPM, (200) and a second one (IN2) of said inputs of said combiner (110); and
- circuitry (120; 220) for arrangement in at least one of the first signal path and the second signal path and configured to at least partially provide isolation between the first main output (Sout) and the second output (Fout) of said Silicon Photomultiplier, SiPM, (200) during operation.

2. The readout circuit (100) of claim 1, wherein said circuitry (120) comprises a first filter circuit (121; 221) arranged in the first signal path between said first main output (Sout) of said Silicon Photomultiplier, SiPM, (200) and a first one (IN1) of said inputs of said combiner (110).

3. The readout circuit (100) of claim 2, wherein said first filter circuit (121; 221) is configured to adjust the signal level of the signal originating from said first main output (Sout) and at least partially provide isolation between the first main output (Sout) and the second output (Fout).

4. The readout circuit (100) of claim 2 or 3, wherein said circuitry (120) further comprises a second filter circuit (122; 222) arranged in the second signal path between said second output (Fout) of said Silicon Photomultiplier, SiPM, (200) and a second one (IN2) of said inputs of said combiner (110).

5. The readout circuit (100) of claim 4, wherein said first filter circuit (121; 221) and said second filter circuit (122; 222) are configured to terminate the signals originating from the first main output (Sout) and the second output (Fout), respectively, to provide isolation between the first main output (Sout) and the second output (Fout).

6. The readout circuit (100) of claim 4 or 5, wherein said second filter circuit (122; 222) is configured to adjust the signal level of the signal originating from said second output (Fout).

7. The readout circuit of any of the claims 4 to 6, wherein said readout circuit is at least partially a digital readout circuit comprising analog-to-digital converters for converting the signals originating from said first main output (Sout) and said second output (Fout) of said Silicon Photomultiplier, SiPM, (200) into respective digital signals, and said first filter circuit (121; 221) and said second filter circuit (122; 222) are digital filters and said combiner (110) is a digital combiner.

8. The readout circuit (100) of any of the claims 1 to 7, wherein said circuitry (120) includes passive and/or active circuitry.

9. A circuit assembly (300) comprising a Silicon Photomultiplier, SiPM, (200) and a readout circuit (100) according to any of the claims 1 to 8.

10. The circuit assembly of claim 9, wherein said Silicon Photomultiplier, SiPM, (200) is connected to said readout circuit (100).

11. A Silicon Photomultiplier, SiPM, (200) comprising a readout circuit (100) according to any of the claims 1 to 8.

12. The Silicon Photomultiplier, SiPM, (200) of claim 11, wherein said readout circuit (100) is integrated into the Silicon Photomultiplier, SiPM, (200).

13. An optical receiver (400) comprising a circuit assembly (300) of any of the claims 9 to 10 or a Silicon Photomultiplier, SiPM, (200) according to any of the claims 11 to 12.

14. The optical receiver of claim 13, wherein the optical receiver (400) is configured to operate based on On-Off Keying, OOK, and/or Pulse Amplitude Modulation, PAM, for Optical Wireless Communication, OWC.

15. An optical transceiver system (500) comprising an optical receiver (400) according to any of the claims 13 to 14, and an optical transmitter (450).

## Patentansprüche

1. Ausleseschaltung (100) für einen Siliciumfotovervielfacher, SiPM, (200), wobei der Siliciumfotovervielfacher, SiPM, (200) einen ersten Hauptausgang (Sout) sowie einen kapazitiv gekoppelten zweiten Ausgang (Fout) aufweist, wobei die Ausleseschaltung (100) umfasst:
- einen Kombinator (110), der Eingänge (IN1, IN2) zum Empfangen von Signalen, die von dem ersten Hauptausgang (Sout) und dem zweiten Ausgang (Fout) des Siliciumfotovervielfachers, SiPM, (200) stammen, aufweist und konfiguriert ist, um basierend auf den empfangenen Signalen ein kombiniertes Signal zu erzeugen,
einen ersten Signalpfad, der zwischen dem ersten Hauptausgang (Sout) des Siliciumfotovervielfachers, SiPM, (200) und einem ersten einen (IN1) der Eingänge des Kombinators (110) definiert ist; und
einen zweiten Signalpfad, der zwischen dem zweiten Ausgang (Fout) des Siliciumfotovervielfachers, SiPM, (200) und einem zweiten einen (IN2) der Eingänge des Kombinators (110) definiert ist; und
- eine Schaltlogik (120; 220) für eine Anordnung in mindestens einem des ersten Signalpfads und des zweiten Signalpfads und die konfiguriert ist, um während eines Betriebs mindestens teilweise eine Isolierung zwischen dem ersten Hauptausgang (Sout) und dem zweiten Ausgang (Fout) des Siliciumfotovervielfachers, SiPM, (200) bereitzustellen.

2. Ausleseschaltung (100) nach Anspruch 1, wobei die Schaltlogik (120) eine erste Filterschaltung (121; 221) umfasst, die in dem ersten Signalpfad zwischen dem ersten Hauptausgang (Sout) des Siliciumfotovervielfachers, SiPM, (200) und einem ersten einen (IN1) der Eingänge des Kombinators (110) angeordnet ist.

3. Ausleseschaltung (100) nach Anspruch 2, wobei die erste Filterschaltung (121; 221) konfiguriert ist, um den Signalpegel des Signals, das von dem ersten Hauptausgang (Sout) stammt, einzustellen und mindestens teilweise die Isolierung zwischen dem ersten Hauptausgang (Sout) und dem zweiten Ausgang (Fout) bereitzustellen.

4. Ausleseschaltung (100) nach Anspruch 2 oder 3, wobei die Schaltlogik (120) ferner eine zweite Filterschaltung (122; 222) umfasst, die in dem zweiten Signalpfad zwischen dem zweiten Ausgang (Fout) des Siliciumfotovervielfachers, SiPM, (200) und einem zweiten einen (IN2) der Eingänge des Kombinators (110) angeordnet ist.

5. Ausleseschaltung (100) nach Anspruch 4, wobei die erste Filterschaltung (121; 221) und die zweite Filterschaltung (122; 222) konfiguriert sind, um die Signale, die von dem ersten Hauptausgang (Sout) beziehungsweise dem zweiten Ausgang (Fout) stammen, zu beenden, um die Isolierung zwischen dem ersten Hauptausgang (Sout) und dem zweiten Ausgang (Fout) bereitzustellen.

6. Ausleseschaltung (100) nach Anspruch 4 oder 5, wobei die zweite Filterschaltung (122; 222) konfiguriert ist, um den Signalpegel des Signals, das von dem zweiten Ausgang (Fout) stammt, einzustellen.

7. Ausleseschaltung nach einem der Ansprüche 4 bis 6, wobei die Ausleseschaltung mindestens teilweise eine digitale Ausleseschaltung ist, umfassend Analog-Digital-Wandler zum Umwandeln der Signale, die von dem ersten Hauptausgang (Sout) und dem zweiten Ausgang (Fout) des Siliciumfotovervielfachers, SiPM, (200) stammen, in jeweilige digitale Signale, und die erste Filterschaltung (121; 221) und die zweite Filterschaltung (122; 222) digitale Filter sind und der Kombinator (110) ein digitaler Kombinator ist.

8. Ausleseschaltung (100) nach einem der Ansprüche 1 bis 7, wobei die Schaltlogik (120) eine passive und/oder aktive Schaltlogik einschließt.

9. Schaltungsbaugruppe (300), umfassend einen Siliciumfotovervielfacher, SiPM, (200) und eine Ausleseschaltung (100) nach einem der Ansprüche 1 bis 8.

10. Schaltungsbaugruppe nach Anspruch 9, wobei der Siliciumfotovervielfacher, SiPM, (200) mit der Ausleseschaltung (100) verbunden ist.

11. Siliciumfotovervielfacher, SiPM, (200), umfassend eine Ausleseschaltung (100) nach einem der Ansprüche 1 bis 8.

12. Siliciumfotovervielfacher, SiPM, (200) nach Anspruch 11, wobei die Ausleseschaltung (100) in den Siliciumfotovervielfacher, SiPM, (200) integriert ist.

13. Optischer Empfänger (400), umfassend eine Schaltungsbaugruppe (300) nach einem der Ansprüche 9 bis 10 oder einen Siliciumfotovervielfacher, SiPM, (200) nach einem der Ansprüche 11 bis 12.

14. Optischer Empfänger nach Anspruch 13, wobei der optische Empfänger (400) konfiguriert ist, um basierend auf einer Ein-Aus-Tastung, OOK, und/oder einer Pulsamplitudenmodulation, PAM, für eine optische drahtlose Kommunikation, OWC, in Betrieb zu sein.

15. Optisches Sendeempfängersystem (500), umfassend einen optischen Empfänger (400) nach einem der Ansprüche 13 bis 14 und einen optischen Sender (450).

## Revendications

1. Circuit de lecture (100) destiné à un photomultiplicateur au silicium, SiPM, (200), ledit photomultiplicateur au silicium, SiPM, (200) ayant une première sortie principale (Sout) ainsi qu'une seconde sortie (Fout) couplée de manière capacitive, dans lequel ledit circuit de lecture (100) comprend :
- un combineur (110) ayant des entrées (IN1, IN2) permettant de recevoir des signaux ayant pour origine ladite première sortie principale (Sout) et ladite seconde sortie (Fout) dudit photomultiplicateur au silicium, SiPM, (200) et configuré pour générer un signal combiné en fonction des signaux reçus,
un premier trajet de signal étant défini entre ladite première sortie principale (Sout) dudit photomultiplicateur au silicium, SiPM, (200) et une première (IN1) desdites entrées dudit combineur (110) ; et
un second trajet de signal étant défini entre ladite seconde sortie (Fout) dudit photomultiplicateur au silicium, SiPM, (200) et une seconde (IN2) desdites entrées dudit combineur (110) ; et
- un système de circuits (120 ; 220) pour agencement dans au moins l'un parmi le premier trajet de signal et le second trajet de signal et configuré pour fournir au moins partiellement un isolement entre la première sortie principale (Sout) et la seconde sortie (Fout) dudit photomultiplicateur au silicium, SiPM, (200) pendant le fonctionnement.

2. Circuit de lecture (100) selon la revendication 1, dans lequel ledit système de circuits (120) comprend un premier circuit de filtre (121 ; 221) agencé dans le premier trajet de signal entre ladite première sortie principale (Sout) dudit photomultiplicateur au silicium, SiPM, (200) et une première (IN1) desdites entrées dudit combineur (110).

3. Circuit de lecture (100) selon la revendication 2, dans lequel ledit premier circuit de filtre (121 ; 221) est configuré pour ajuster le niveau de signal du signal ayant pour origine ladite première sortie principale (Sout) et fournir au moins partiellement un isolement entre la première sortie principale (Sout) et la seconde sortie (Fout).

4. Circuit de lecture (100) selon la revendication 2 ou 3, dans lequel ledit système de circuits (120) comprend en outre un second circuit de filtre (122 ; 222) agencé dans le second trajet de signal entre ladite seconde sortie (Fout) dudit photomultiplicateur au silicium, SiPM, (200) et une seconde (IN2) desdites entrées dudit combineur (110).

5. Circuit de lecture (100) selon la revendication 4, dans lequel ledit premier circuit de filtre (121 ; 221) et ledit second circuit de filtre (122 ; 222) sont configurés pour terminer les signaux ayant pour origine la première sortie principale (Sout) et la seconde sortie (Fout), respectivement, pour fournir un isolement entre la première sortie principale (Sout) et la seconde sortie (Fout).

6. Circuit de lecture (100) selon la revendication 4 ou 5, dans lequel ledit second circuit de filtre (122 ; 222) est configuré pour ajuster le niveau de signal du signal ayant pour origine ladite seconde sortie (Fout).

7. Circuit de lecture selon l'une quelconque des revendications 4 à 6, dans lequel ledit circuit de lecture est au moins partiellement un circuit de lecture numérique comprenant des convertisseurs analogiques vers numériques permettant de convertir les signaux ayant pour origine ladite première sortie principale (Sout) et ladite seconde sortie (Fout) dudit photomultiplicateur au silicium, SiPM, (200) en signaux numériques respectifs, et ledit premier circuit de filtre (121 ; 221) et ledit second circuit de filtre (122 ; 222) sont des filtres numériques et ledit combineur (110) est un combineur numérique.

8. Circuit de lecture (100) selon l'une quelconque des revendications 1 à 7, dans lequel ledit système de circuits (120) comporte un système de circuits passif et/ou actif.

9. Ensemble circuit (300) comprenant un photomultiplicateur au silicium, SiPM, (200) et un circuit de lecture (100) selon l'une quelconque des revendications 1 à 8.

10. Ensemble circuit selon la revendication 9, dans lequel ledit photomultiplicateur au silicium, SiPM, (200) est connecté audit circuit de lecture (100).

11. Photomultiplicateur au silicium, SiPM, (200) comprenant un circuit de lecture (100) selon l'une quelconque des revendications 1 à 8.

12. Photomultiplicateur au silicium, SiPM, (200) selon la revendication 11, dans lequel ledit circuit de lecture (100) est intégré dans le photomultiplicateur au silicium, SiPM, (200).

13. Récepteur optique (400) comprenant un ensemble circuit (300) selon l'une quelconque des revendications 9 à 10 ou un photomultiplicateur au silicium, SiPM, (200) selon l'une quelconque des revendications 11 à 12.

14. Récepteur optique selon la revendication 13, dans lequel le récepteur optique (400) est configuré pour fonctionner en fonction d'une modulation par tout ou rien, OOK, et/ou d'une modulation d'impulsions en amplitude, PAM, pour une communication optique sans fil, OWC.

15. Système émetteur-récepteur optique (500) comprenant un récepteur optique (400) selon l'une quelconque des revendications 13 à 14, et un émetteur optique (450).
